# EUROPEAN PATENT SPECIFICATION

(11) **EP 1 026 271 B1**
(45) Date of publication and mention of the grant of the patent: **15.01.2003**
(21) Application number: 00101940.5
(22) Date of filing: 01.02.2000
(51) Int. Cl.: C22C 29/08, C22C 1/05

(54) **Cemented carbide insert**
Sinterkarbideinsatz
Plaquette de carbure fritté

(30) Priority: 05.02.1999 SE 9900403
(43) Date of publication of application: 09.08.2000
(73) Proprietor: SANDVIK AKTIEBOLAG, 811 81 Sandviken (SE)
(72) Inventor: Palmqvist, Lisa, 412 62 Göteborg (SE); Lenander, Anders, 135 53 Tyresö (SE); Lindholm, Mikael, 126 36 Hägersten (SE); Ljungberg, Björn, 122 44 Enskede (SE); Thysell, Michael, 141 60 Huddinge (SE)
(74) Representative: Taquist, Lennart

(56) References cited:
- EP-A- 0 737 756
- EP-A- 0 753 603
- WO-A-97/09463
- WO-A-98/03691
- WO-A-98/16665

## Description

The present invention relates to a coated cutting tool insert particularly useful for turning of steel, like low alloyed steels, carbon steels and tough hardened steels at high cutting speeds. The insert is based on WC, cubic carbides and a Co-binder phase. It has surface zones with element compositions differing from the bulk composition giving simultaneously an excellent resistance to plastic deformation and high toughness performance.

High performance cutting tools must nowadays possess high wear resistance, high toughness properties and good resistance to plastic deformation. This is particularly valid when the cutting operation is carried out at very high cutting speeds and/or at high feed rates when large amount of heat is generated.

Improved resistance to plastic deformation of a cutting insert can be obtained by decreasing the WC grain size and/or by lowering the overall binder phase content, but such changes will simultaneously result in significant loss in the toughness properties of the insert.

Methods to improve the toughness behaviour by introducing a thick essentially cubic carbide free and binder phase enriched surface zone with a thickness of about 20-40 µm on the inserts by a so called gradient sintering techniques are known.

However, these methods produce a rather hard cutting edge due to a depletion of binder phase and enrichment of cubic phases along the cutting edge. A hard cutting edge is more prone to chipping. Nevertheless, such cemented carbide inserts with essentially cubic carbide free and binder phase enriched surface zones are extensively used today for machining steel and stainless steel.

There are ways to overcome the problem with the edge brittleness by controlling the carbide composition along the cutting edge by employing special sintering techniques or by using certain alloying elements e.g. US 5,484,468, US 5,549,980 and US 5,729,823 or US 5,643,658.

All these techniques give a binder phase enrichment in the outermost region of the edge. However, inserts produced according to these techniques often obtain micro plastic deformation at the outermost part of the cutting edge. In particular, this often occurs when the machining is carried out at high cutting speeds. A micro plastic deformation of the cutting edge will cause a rapid flank wear and hence a shortened lifetime of the cutting inserts. A further drawback of the above-mentioned techniques is that they are complex and difficult to fully control.

US 5,786,069 and US 5,863,640 disclose coated cutting tool inserts with a binder phase enriched surface zone and a highly W-alloyed binder phase.

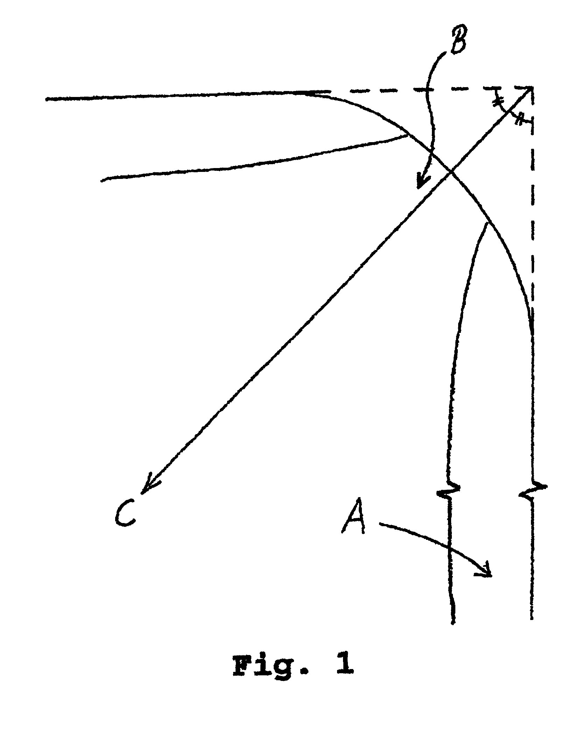

Figure 1 is a schematic drawing of a cross section of an edge of an insert gradient sintered according to the present invention where
A = binder phase enriched surface zone
B = cutting edge near zone
C = a line essentially bisecting the edge.

It has now surprisingly been found that significant improvements with respect to resistance to plastic deformation and toughness behaviour can simultaneously be obtained for a cemented carbide insert if a number of features are combined. The improvement in cutting performance of the cemented carbide inserts can be obtained if the cobalt binder phase is highly alloyed with W, if the essentially cubic carbide free and binder phase enriched surface zone A has a certain thickness and composition, if the cubic carbide composition near the cutting edge B is optimised and if the insert is coated with a 3-12 µm columnar TiCN-layer followed by a 2-12 µm thick Al₂O₃-layer e.g. produced according to any of the patents US 5,766,782, US 5,654,035, US 5,674,564 or US 5,702,808 possibly with an outermost layer of 0.5-4 µm TiN. The Al₂O₃-layer will serve as an effective thermal barrier during cutting and thereby im-an appropriate technique like by brushing with a SiC-based nylon brush or by a gentle blasting with Al₂O₃ grains the cutting performance can be enhanced further, in particular with respect to flaking resistance of the coating (see US 5,861,210).

Said cutting insert possesses excellent cutting performance when machining steel at high cutting speeds, in particular low alloyed steels, carbon steels and tough hardened steels. As a result a wider application area for the coated carbide insert is obtained because the cemented carbide insert according to the invention performs very well at both low and very high cutting speeds under both continuous and intermittent cutting conditions.

According to the present invention given by claim 1, there is now provided a coated cemented carbide insert with a , 5-15. µm, thick cubic carbide free and binder phase enriched surface zone A (Fig. 1). In order to obtain high resistance to plastic deformation but simultaneously avoid a brittle cutting edge the chemical composition is optimised in zone B (Fig.1). Along line C (Fig. 1), in the direction from edge to the centre of the insert, the binder phase content increases uniformly until it reaches the bulk composition. At the edge the binder phase content in vol-% is 0.65-0.75, preferably about 0.7 times the binder phase content of the bulk. In a similar way, the cubic carbide phase content decreases along line C from about 1.3 times the content of the bulk. The depth of the binder phase depletion and cubic carbide enrichment along line C is 100-300 µm, preferably 150-250 µm.

The binder phase is highly W-alloyed. The content of W in the binder phase can be expressed as a${\text{CW-ratio = M}}_{\text{S}} \text{/(wt-% Co · 0.0161)}$ where
M_{S} is the measured saturation magnetisation of the cemented carbide body in kA/m and wt-% Co is the weight percentage of Co in the cemented carbide. The CW-ratio takes a value ≤1 and the lower the CW-ratio is the higher is the W-content in the binder phase. It has been found that an improved cutting performance is achieved if the CW-ratio is 0.75-0.90.

Inserts according to the invention are further provided with a coating consisting of 3-12 µm columnar TiCN-layer followed by a 2-12 µm thick Al₂O₃-layer deposited e.g. according to any of the patents US 5,766,782, US 5,654,035, US 5,674,564, US 5,702,808 preferably with an α-Al₂O₃-layer possibly with an outermost layer of 0.5-4 µm TiN.

The present invention is applicable to cemented carbides with a composition of 4-7, weight percent of binder phase consisting of Co, and 7-10, weight percent cubic carbides of the metals from groups IVa, Va or VIa of the periodic table, preferably >1 wt% of each Ti, Ta and Nb and a balance WC. The WC has an average grain size of 1.0 to 4.0 µm, preferably 2.0 to 3.0 µm. The cemented carbide body may contain small amounts, <1 volume-%, of η-phase (M₆C).

The invention also relates to a method of making cutting inserts as given in claim 9 comprising a cemented carbide substrate consisting of a binder phase of Co, WC and a cubic carbonitride phase with a binder phase enriched surface zone free of cubic phase and a coating. The powder mixture contains 4-7, weight percent of binder phase consisting of Co, and 7-10, weight percent cubic carbides of the metals from groups IVa, Va or VIa of the periodic table, preferably >1 wt% of each Ti, Ta and Nb and a balance WC with an average grain size of 1.0-4.0 µm, preferably 2.0-3.0 µm. Well-controlled amounts of nitrogen have to be added either through the powder as carbonitrides or/and added during the sintering process via the sintering gas atmosphere. The amount of added nitrogen will determine the rate of dissolution of the cubic phases during the sintering process and hence determine the overall distribution of the elements in the cemented carbide after solidification. The optimum amount of nitrogen to be added depends on the composition of the cemented carbide and in particular on the amount of cubic phases and varies between and 1.1-1.4%, of the weight of the elements from groups IVa and Va of the periodic table. The exact conditions depend to a certain extent on the design of the sintering equipment being used. It is within the purview of the skilled artisan to determine whether the requisite surface zones A and B of cemented carbide have been obtained and to modify the nitrogen addition and the sintering process in accordance with the present specification in order to obtain the desired result.

The raw materials are mixed with pressing agent and possibly W such that the desired CW-ratio is obtained and the mixture is milled and spray dried to obtain a powder material with the desired properties. Next, the powder material is compacted and sintered. Sintering is performed at a temperature of 1300-1500°C, in a controlled atmosphere of about 5kPa (50 mbar) followed by cooling. After conventional post sintering treatments including edge rounding a hard, wear resistant coating according to above is applied by CVD- or MT-CVD-technique.

### Example 1

**A.)** Cemented carbide turning inserts of the style CNMG 120408-PM, DNMG150612-PM and CNMG160616-PR, with the composition 5.5 wt% Co, 3.5 wt% TaC, 2.3 wt% NbC, 2.1 wt% TiC and 0.4 wt% TiN and balance WC with an average grain size of 2.5 µm were produced according to the invention. The nitrogen was added to the carbide powder as TiCN. Sintering was done at 1450 °C in a controlled atmosphere consisting of Ar, CO and some N₂ at a total pressure of about 5kPa (50 mbar)
   Metallographic investigation showed that the produced cemented carbide inserts had a cubic-carbide-free zone A with a thickness of 10 µm. Image analysis technique was used to determine the phase composition at zone B and the area along line C (Fig. 1). The measurements were done on polished cross sections of the inserts over an area of about 40 x 40 µm gradually moving along the line C. The phase composition was determined as volume fractions. The analysis showed that the cobalt content in zone B was 0.7 times the bulk cobalt content and the cubic carbide content 1.3 times the bulk cubic carbide content. The measurements of the bulk content were also done by image analysis technique. The Co-content was gradually increasing and the cubic carbide content gradually decreasing along line C in the direction from the edge to the centre of the insert.
   Magnetic saturation values were recorded and used for calculating CW-values. An average CW-value of 0.84 was obtained.
**B.)** Inserts from **A** were first coated with a thin layer <1 µm of TiN followed by 6 µm thick layer of TiCN with columnar grains by using MTCVD-techniques (process temperature 850 °C and CH₃CN as the carbon/nitrogen source). In a subsequent process step during the same coating cycle, an 8 µm thick α-Al₂O₃ layer was deposited according to patent US 5,654,035. On top of the α-Al₂O₃ layer a 1.5 µm TiN layer was deposited.
**C.)** Inserts from **A** were first coated by a thin layer <1 µm of TiN followed by a 9 µm thick TiCN-layer and a 5 µm thick α-Al₂O₃ layer and a 2 µm thick TiN layer on top. The same coating procedures as given in A.) were used.
**D.)** Commercially available cutting insert in style CNMG 120408-PM, DNMG150612-PM and CNMG160616-PR, with the composition given below were used as references in the cutting tests:
   Composition: Co = 5.5 wt%, TaC = 3.5 wt%, NbC = 2.3 wt%, TiC = 2.6 wt% and balance WC with a grain size 2.6 µm. Cobalt enriched gradient zone: none subsequent process step during the same coating cycle, an 8 µm thick α-Al₂O₃ layer was deposited according to patent US 5,654,035. On top of the α-Al₂O₃ layer a 1.5 µm TiN layer was deposited.
**C.)** Inserts from **A** were first coated by a thin layer <1 µm of TiN followed by a 9 µm thick TiCN-layer and a 5 µm thick α-Al₂O₃ layer and a 2 µm thick TiN layer on top. The same coating procedures as given in A.) were used.
**D.)** Commercially available cutting insert in style CNMG 120408-PM, DNMG150612-PM and CNMG160616-PR, with the composition given below were used as references in the cutting tests:
   Composition: Co = 5.5 wt%, TaC = 3.5 wt%, NbC = 2.3 wt%,
   TiC = 2.6 wt% and balance WC with a grain size 2.6 µm.
   Cobalt enriched gradient zone: none
   CW-ratio: > 0.95
   Coating: 8 µm TiCN, 6 µm Al₂O₃, and 0.5 µm TiN on top
**E.)** Inserts with the same cemented carbide composition as in D were coated with 4 µm TiCN and 6 µm Al₂O₃. Insert styles CNMG120408-QM and CNMG120412-MR.
**F.)** Inserts in styles CNMG120408-QM and CNMG120412-MR with the composition: 4.7 wt% Co, 3.1 wt% TaC, 2.0 wt% NbC, 3.4 wt%, TiC 0.2 wt% N and rest WC with a grain size of 2.5 µm were produced. The inserts were sintered according to the method described in patent US 5,484,468 i.e. a method that gives cobalt enrichment in zone B. The sintered carbide inserts had a 25 µm thick gradient zone essentially free from cubic carbide. The inserts were coated with the same coating as in **E.**

### Example 2

Inserts from **B** and **C** were tested and compared with inserts from **D** with respect to toughness in a longitudinal turning operation with interrupted cuts.
Material: Carbon steel SS1312.
Cutting data:
Cutting speed 140 m/min
Depth of cut 2.0 mm
Feed Starting with 0.12 mm and gradually increased by 0.08 mm/min until breakage of the edge
15 edges of each variant were tested.
Insert style: CNMG120408-PM

| Results: | |
|---|---|
| | Mean feed at breakage |
| Inserts B | 0.23 mm/rev |
| Inserts C | 0.23 mm/rev |
| Inserts D | 0.18 mm/rev |

### Example 3

Inserts from **B**, **C** and **D** were tested with respect to resistance to plastic deformation in longitudinal turning of alloyed steel (AISI 4340).

| Cutting data: | |
|---|---|
| Cutting speed | 160 m/min |
| Feed | 0.7 mm/rev. |
| Depth of cut | 2 mm |
| Time in cut | 0.50 min |

The plastic deformation was measured as the edge depression at the nose of the inserts.

| Results: | |
|---|---|
| | Edge depression, µm |
| Insert B | 43 |
| Insert C | 44 |
| Insert D | 75 |

Examples 2 and 3 show that the inserts **B** and **C** according to the invention exhibit much better plastic deformation resistance in combination with somewhat better toughness behaviour in comparison to the inserts **D** according to prior art.

### Example 4

Inserts from **E** and **F** were tested with respect to flank wear resistance in longitudinal turning of ball bearing steel SKF25B.

| Cutting data: | |
|---|---|
| Cutting speed | 320 m/min |
| Feed | 0.3 mm/rev. |
| Depth of cut | 2 mm |

Tool life criteria: Flank wear ≥ 0.3 mm

| Results: | |
|---|---|
| | Tool life |
| Insert E | 8 min |
| Insert F | 6 min |

Variant **F** exhibited micro plastic deformation resulting in more rapid development of the flank wear.

### Example 5

Inserts from **E** and **F** in insert style CNMG120412-MR were tested at an end user in machining of a steel casting component.

| Cutting data: | |
|---|---|
| Cutting speed | 170-180 m/min |
| Feed | 0.18 mm/rev. |
| Depth of cut | 3 mm |

The component had the shape of a ring. The inserts machined two components each and the total time in cut was 13.2 min.

After the test the flank wear of the inserts was measured.

| Results: | |
|---|---|
| | Flank wear |
| Insert E | 0.32 mm |
| Insert F | 0.60 mm |

Examples 4 and 5 illustrate the detrimental effect of cobalt enrichment in the edge area B typical for inserts produced by prior art gradient sintering technique as described in e.g. US 5,484,468.

### Example 6

Inserts from **B** and **D** were tested under the same condition as in Example 4. Insert style was CNMG120408-PM.

| Cutting data: | |
|---|---|
| Cutting speed | 320 m/min |
| Feed | 0.3 mm/rev. |
| Depth of cut | 2 mm |

Tool life criteria: Flank wear ≥0.3 mm

| Results: | Tool life |
|---|---|
| Insert B | 8 min |
| Insert D | 8 min |

### Example 7

Inserts from **B** and **D** were tested at an end user in the machining of cardan shafts in tough hardened steel. Insert style was DNMG150612-PM.

| Cutting condition: | |
|---|---|
| Cutting speed | 150 m/min |
| Feed | 0.3 mm/rev. |
| Depth of cut | 3 mm |

The inserts machined 50 component each. Afterwards the flank wear of the inserts was measured.

| Results: | |
|---|---|
| | Flank wear |
| Insert B | 0.15 mm |
| Insert D | 0.30 mm |

Examples 6 and 7 illustrate that inserts with an optimised edge zone B composition according to the invention do not suffer from micro plastic deformation and hence no rapid flank wear as prior art gradient sintered insert F does (see examples 4 and 5).

### Example 8

In a test performed at an end-user inserts from **B, C** and **D** in style CNMG160616-PR were run in a longitudinal turning operation in machining of crankshaft in low alloyed steel.

The inserts were allowed to machine 90 crankshafts and the flank wear was measured and compared.

| Cutting data: | |
|---|---|
| Cutting speed | 220 m/min |
| Feed | 0.6 mm/rev. |
| Depth of cut | 3-5 mm |
| Total time in cut | 27 min. |

The dominating wear mechanism was plastic deformation of the type edge impression causing a flank wear.

| Results: | |
|---|---|
| | Flank wear |
| Insert B | 0.2 mm |
| Insert C | 0.2 mm |
| Insert D | 0.6 mm |

The example illustrates the superior resistance to plastic deformation of the inserts **B** and **C** produced accord- ing to the invention compared to prior art inserts **D**.

## Claims

1. A cutting tool insert for turning of steel comprising a cemented carbide body and a coating
wherein
- the cemented carbide body consists of WC with an average grain size of 1.0-4.0 µm, 4-7 wt-% Co and 7-10 wt-% of cubic carbides of metals from groups IVa, Va or VIa of the periodic table whereby N is added in an amount of 1.3-1.4%, of the weight of the elements from groups IVa and Va
- the Co-binder phase is highly alloyed with W with a CW-ratio of 0.75-0.90
- the cemented carbide body has a binder phase enriched and cubic carbide free surface zone A (see Figure 1) of a thickness of 5-15 µm
- the cemented carbide body has along a line C see Figure 1, bisecting the edge, in the direction from edge to the centre of the insert, a binder phase content increasing uniformly until it reaches the bulk composition from a binder phase content in vol-% at the edge of 0.65-0.75 times the binder phase content of the bulk whereby the depth of the binder phase depletion is 100-300 µm,
- the coating comprises a coating consisting of 3-12 µm columnar TiCN-layer followed by a 2-12 µm thick Al₂O₃-layer.

2. A cutting tool insert according to claim 1 **characterised in that** the said Al₂O₃-layer is α-Al₂O₃.

3. A cutting tool insert according to any of the previous claims **characterised in** an outermost 0.5-4 µm thick layer of TiN.

4. A cutting tool insert according to any of the previous claims **characterised in that** the cutting edge is smoothed by brushing or by blasting.

5. A cutting tool insert according to any of the previous claims **characterised in that** the average WC-grain size is 2.0-3.0 µm.

6. A cutting tool insert according to any of the previous claims **characterised in** containing >1% of each Ti, Ta and Nb.

7. A cutting tool insert according to any of the previous claims **characterised in** a binder phase content in vol-% at the edge of 0.7 times the binder phase content of the bulk.

8. A cutting tool insert according to any of the previous claims **characterised in** a depth of the binder phase depletion of 150-250 µm.

9. Method of making a cutting insert comprising a cemented carbide substrate with a binder phase enriched surface zone and a coating, said substrate consisting of a binder phase of Co, WC and a cubic carbonitride phase, said binder phase enriched surface zone being free of said cubic carbonitride phase and with a constant thickness around the insert wherein forming a powder mixture containing WC, 4-7 weight percent Co and 7-10 weight percent cubic carbides of the metals from groups IVa, Va or VIa of the periodic table whereby N is added in an amount of between 1.1 and 1.4 of the weight of the elements from groups IVa and Va
mixing said powders with pressing agent and possibly W such that the desired CW-ratio of 0.75-0.90 is-obtained
milling and spray drying the mixture to a powder material with the desired properties
compacting and sintering the powder material at a temperature of 1300-1500°C, in a controlled atmosphere of about 5 kPa (50 mbar) followed by cooling
applying conventional post sintering treatments including edge rounding and
applying a hard, wear resistant coating comprising a 3-12 µm columnar TiCN-layer followed by a 2-12 µm thick Al₂O₃-layer by CVD- or MT-CVD-technique.

10. Method according to according to claim 9 **characterised in** containing >1% of each Ti, Ta and Nb.

## Patentansprüche

1. Schneidwerkzeugeinsatz zum Stahldrehen, der einen Hartmetallkörper und eine Beschichtung umfasst, wobei
- der Hartmetallkörper aus WC mit einer mittleren Korngröße von 1,0 bis 4,0 µm, 4 bis 7 Gew.% Co und 7 bis 10 Gew.% kubischen Carbiden von Metallen aus den Gruppen IVa, Va oder Vla des Periodensystems besteht, wobei N in einer Menge von 1,1 bis 1,4 % des Gewichtes der Elemente aus den Gruppen IVa und Va zugesetzt wird,
- die Co-Bindephase mit W zu einem CW-Verhältnis von 0,75 bis 0,90 stark legiert ist,
- der Hartmetallkörper eine angereicherte Bindephase und eine von kubischen Carbiden freie Oberflächenzone A (siehe Fig. 1) mit einer Dicke von 5 bis 15 µm hat,
- der Hartmetallkörper entlang einer Linie C (siehe Fig. 1), die die Kante in der Richtung von der Kante zu der Mitte des Einsatzes halbiert, einen Bindephasengehalt hat, der gleichmäßig zunimmt, bis er die Massenzusammensetzung aus einem Bindephasengehalt in Volumenprozenten vom 0,65- bis 0,75fachen des Bindephasengehaltes der Masse ist, wobei die Tiefe der Bindephasenverarmung 100 bis 300 µm ist und
- die Beschichtung einen Überzug umfasst, welcher aus 3 bis 12 µm säulenartiger TiCN-Schicht und anschließend einer 2 bis 12 µm dicken Al₂O₃-Schicht besteht.

2. Schneidwerkzeugeinsatz nach Anspruch 1, **dadurch gekennzeichnet, dass** die Al₂O₃-Schicht α-Al₂O₃ ist,

3. Schneidwerkzeugeinsatz nach einem der vorausgehenden Ansprüche, **gekennzeichnet durch** eine äußerste 0,5 bis 4 µm dicke Schicht aus TiN.

4. Schneidwerkzeugeinsatz nach einem der vorausgehenden Ansprüche, **dadurch gekennzeichnet, dass** die Schneidkante durch Bürsten oder Sandstrahlen geglättet ist.

5. Schneidwerkzeugeinsatz nach einem der vorausgehenden Ansprüche, **dadurch gekennzeichnet, dass** die mittlere WC-Korngröße 2,0 bis 3,0 µm beträgt.

6. Schneidwerkzeugeinsatz nach einem der vorausgehenden Ansprüche, **dadurch gekennzeichnet, dass** er >1 % jeweils von Ti, Ta und Nb enthält.

7. Schneidwerkzeugeinsatz nach einem der vorausgehenden Ansprüche, **dadurch gekennzeichnet, dass** der Bindephasengehalt in Volumenprozenten an der Kante das 0,7fache des Bindephasengehaltes der Masse ist.

8. Schneidwerkzeugeinsatz nach einem der vorausgehenden Ansprüche, **gekennzeichnet durch** eine Tiefe der Bindephasenverarmung von 150 bis 250 µm.

9. Verfahren zur Herstellung eines Schneideinsatzes, der ein Hartmetallsubstrat mit einer an Bindephase angereicherten Oberflächenzone und eine Beschichtung umfasst, wobei dieses Substrat aus einer Bindephase von Co, WC und einer kubischen Carbonitridphase besteht, die an Bindephase angereicherte Oberflächenzone frei von der kubischen Carbonitridphase ist und eine konstante Dicke um den Einsatz herum hat, wobei ein Pulvergemisch gebildet wird, das WC, 4 bis 7 Gew.% Co und 7 bis 10 Gew.% kubische Carbide der Metalle aus den Gruppen IVa, Va oder VIa des Periodensystems enthält, wobei N in einer Menge zwischen 1,1 und 1,4 des Gewichtes der Elemente aus den Gruppen IVa und Va zugegeben wird,
diese Pulver mit Pressmittel und gegebenenfalls W vermischt, so dass das erwünschte CW-Verhältnis 0,75 bis 0,90 erhalten wird,
das Gemisch mahlt und sprühtrocknet, um ein Pulvermaterial mit den erwünschten Eigenschaften zu bekommen,
das Pulvermaterial bei einer Temperatur von 1300 bis 1500 °C in einer gesteuerten Atmosphäre von etwa 5 kPa (50 mbar) verdichtet und sintert, gefolgt von Kühlen,
herkömmliche Nachsinterbehandlungen einschließlich Kantenabrundung usw., anwendet und eine harte, verschleißbeständige Beschichtung aufbringt, die eine 3 bis 12 µm dicke säulenartige TiCN-Schicht erzeugt, auf die eine 2 bis 12 µm dicke Al₂O₃-Schicht durch CVDoder MT-CVD-Technik erhalten wird.

10. Verfahren nach Anspruch 9, **dadurch gekennzeichnet, dass** er >1 % jedes der Elemente Ti, Ta und Nb enthält.

## Revendications

1. Plaquette d'outil de coupe pour le tournage d'acier comprenant un corps de carbure cémenté et un revêtement, dans laquelle :
- le corps de carbure cémenté est constitué de WC avec une taille moyenne de grains de 1,0 à 4,0 µm, de 4 à 7% en poids de Co, et de 7 à 10% en poids de carbures cubiques des métaux des groupes IVa, Va ou VIa du tableau périodique auquel on ajoute N en une quantité de 1,1 à 1,4% du poids des éléments des groupes IVa et Va ;
- la phase Co-liant est fortement alliée avec W avec un rapport CW de 0,75 à 0,90 ;
- le corps de carbure cémenté possède une zone de surface A enrichie en phase de liant et exempte de carbure cubique (voir figure 1) d'une épaisseur de 5 à 15 µm ;
- le corps de carbure cémenté possède le long d'une ligne C (voir figure 1), bissectant l'arête, dans la direction de l'arête vers le centre de la plaquette, une teneur en phase de liant augmentant uniformément jusqu'à ce qu'elle atteigne la composition de masse à partir d'une teneur en phase de liant en % volumique de 0,65 à 0,75 fois la teneur en phase de liant de la masse grâce à quoi la profondeur de l'appauvrissement de la phase de liant est de 100 à 300 µm ;
- le revêtement comprend un revêtement constitué d'une couche colonnaire de TiCN de 3 à 12 µm de profondeur suivie d'une couche de Al₂O₃ épaisse de 2 à 12 µm.

2. Plaquette d'outil de coupe selon la revendication 1, **caractérisée en ce que** ladite couche de Al2O3 est Al₂O₃ α.

3. Plaquette d'outil de coupe selon l'une quelconque des revendications précédentes **caractérisée par** une couche la plus externe de TiN épaisse de 0,5 à 4 µm.

4. Plaquette d'outil de coupe selon l'une quelconque des revendications précédentes **caractérisée en ce que** l'arête tranchante est lissée par brossage ou par sablage.

5. Plaquette d'outil de coupe selon l'une quelconque des revendications précédentes **caractérisée en ce que** la taille moyenne des grains de WC est de 2,0 à 3,0 µm.

6. Plaquette d'outil de coupe selon l'une quelconque des revendications précédentes **caractérisée en ce qu'**elle contient >1% de chacun de Ti, Ta et Nb.

7. Plaquette d'outil de coupe selon l'une quelconque des revendications précédentes **caractérisée par** une teneur en phase de liant, en % volumique, sur l'arête de 0,7 fois la teneur en phase de liant de la masse.

8. Plaquette d'outil de coupe selon l'une quelconque des revendications précédentes **caractérisée par** une profondeur de l'appauvrissement de la phase de liant de 150 à 250 µm.

9. Procédé de fabrication d'une plaquette de coupe comprenant un substrat de carbure cémenté avec une zone de surface enrichie en phase de liant et un revêtement, ledit substrat étant constitué d'une phase de liant de Co, de WC et une phase de carbonitrure cubique, ladite zone de surface enrichie en phase de liant étant exempte de ladite phase de carbonitrure cubique et avec une épaisseur constante autour de la plaquette, dans lequel :
- on forme un mélange de poudre contenant WC, 4 à 7% en poids de Co et 7 à 10% en poids de carbures cubiques des métaux des groupes IVa, Va ou VIa du tableau périodique, auquel on ajoute N en une quantité comprise entre 1,1 et 1,4 du poids des éléments des groupes IVa et Va ;
- on mélange lesdites poudres avec un agent de pressage et éventuellement W de sorte qu'on obtient le rapport de CW souhaité de 0,75 à 0,90 ;
- on broie et on sèche par pulvérisation le mélange en une matière pulvérulente avec les propriétés souhaitées ;
- on compacte et on fritte la matière pulvérulente à une température comprise entre 1 300°C et 1 500°C, dans une atmosphère régulée d'environ 5 kPa (50 mbars) suivi d'un refroidissement ;
- on applique les traitements post frittage classiques y compris l'arrondissement des bords ; et
- on applique un revêtement dur, résistant à l'usure comprenant une couche colonnaire de TiCN de 3 à 12 µm suivi d'une couche de Al₂O₃ épaisse de 2 à 12 µm au moyen de la technique CVD ou MT-CVD.

10. Procédé selon la revendication 9, **caractérisé en ce qu'**il contient >1% de chacun de Ti, Ta et Nb.
